# EUROPÄISCHE PATENTSCHRIFT

(11) **EP 3 103 169 B1**
(45) Veröffentlichungstag und Bekanntmachung des Hinweises auf die Patenterteilung: **23.10.2019**
(21) Anmeldenummer: 15714161.5
(22) Anmeldetag: 28.01.2015
(51) Int. Cl.: H02B 1/01

(54) **RAHMENPROFIL FÜR EIN RAHMENGESTELL EINES SCHALTSCHRANKES**
FRAME PROFILE FOR AN ELECTRICAL CABINET FRAME
PROFIL DE CADRE POUR UN CHÂSSIS D'UNE ARMOIRE ÉLECTRIQUE

(30) Priorität: 05.02.2014 DE 102014101402
(43) Veröffentlichungstag der Anmeldung: 14.12.2016
(73) Patentinhaber: RITTAL GmbH & Co. KG, 35745 Herborn (DE)
(72) Erfinder: PAUL, Hartmut, 35767 Breitscheid (DE)
(74) Vertreter: Angerhausen, Christoph
(86) Internationale Anmeldenummer: PCT/DE2015/100033
(87) Internationale Veröffentlichungsnummer: WO 2015/117596

(56) Entgegenhaltungen:
- DE-A1- 4 336 187
- GB-A- 2 121 676
- US-A1- 2013 221 813

## Beschreibung

Die Erfindung betrifft ein Rahmenprofil für ein Rahmengestell eines Schaltschrankes. Das Rahmenprofil besteht aus einem Außenteilprofil, das aus einem ersten Material hergestellt ist, wobei das Außenteilprofil zumindest eine erste Wand des Rahmenprofils, die eine Hohlkammer teilweise begrenzt, bildet, und aus einem Innenprofil, das aus einem zweiten Material hergestellt ist, welches von dem ersten Material in mindestens einer Eigenschaft unterschiedlich ist, wobei das Innenprofil zumindest eine weitere Wand der Hohlkammer bildet. Ein derartiges Rahmenprofil ist aus der US 2013/0221813 A1 bekannt.

Rahmenprofile sind in vielfältigen Ausgestaltungen bekannt, lediglich beispielhaft genannt seien Profile gemäß der DE 195 36 950 C1, der EP 0 789 983 B1 und der EP 1 601 074 B1. Alle diese Profile haben eine mehr oder weniger komplexe Struktur, wobei von der Herstellerseite und auch der Benutzerseite her der Wunsch besteht, Material zu sparen und viele Funktionalitäten zur Verfügung zu haben.

Es ist daher die Aufgabe der Erfindung, ein Rahmenprofil für ein Rahmengestell eines Schaltschrankes zur Verfügung zu stellen, das bei gleichbleibender Steifigkeit und Tragfähigkeit für Einhängechassis eine Materialersparnis ermöglicht.

Diese Aufgabe wird durch ein Rahmenprofil nach Anspruch 1 gelöst. Vorteilhafte Ausgestaltungen sind Gegenstand der Unteransprüche. Ein Rahmengestell für einen Schaltschrank, bei dem ein erfindungsgemäßes Rahmenprofil verbaut ist, ist Gegenstand des Anspruchs 13.
Erfindungsgemäß ist die Hohlkammer über die Länge des Rahmenprofils durchgängig ausgeführt und das Innenteilprofil zur Bildung mindestens eines Profilansatzes gefalzt, wobei der Profilansatz mit einer Lochung versehen ist.

Beispielsweise kann das Außenteilprofil aus einem Material bestehen, das korrosiv beständiger ist, als das Material des Innenteilprofils.

Auch kann vorgesehen sein, dass die Stärke des Außenteilprofils von der Stärke des Innenteilprofis unterschiedlich ist, insbesondere größer ist als die Stärke des Innenteilprofils.

Dadurch, dass die Hohlkammerüber die gesamte Länge des Rahmenprofils durchgängig ist, steht in der Hohlkammer ein Optionsraum zur Verfügung, der in vielfältiger Weise genutzt werden kann. So kann daran gedacht werden, Kabel durch die Hohlkammer zu ziehen, beispielsweise für Datenleitungen, die dann durch das Material des Außenteilprofils und des Innenteilprofils abgeschirmt und somit vor Störungen geschützt sind.

Auch kann vorgesehen sein, dass die Hohlkammer mit einem Hartschaum versteift ist. Genauso sind Befüllungen mit Weichschaum denkbar, damit die Hohlkammer dämpfende Eigenschaften entwickelt. Auch können offenporige Strukturen, insbesondere offenporige Weichschäume vorgesehen sein, die einen Medientransport zulassen.

Der Hartschaum oder der Weichschaum kann dabei ein Schaum auf Polyester- oder Polyurethanbasis sein. Auch Metallschäume sind denkbar, ebenso wie Beton und andere anorganische und organische Materialien.

Bei gleichen Funktions- und Außenmaßen ist so eine Vielzahl von Profilen mit unterschiedlichsten Eigenschaften möglich, ohne dass die Funktionsgeometrie verändert wird. So kann der Hohlraum so gestaltet werden, dass sich die Eigenschaften des Profils einstellen lassen.

Nach einer bevorzugten Ausgestaltung der Erfindung können das Außenteilprofil und das Innenteilprofil zu zumindest einem Profilansatz zusammengeführt sein, der sich von der Hohlkammer weg erstreckt. Es entsteht damit ein geradliniger Steg mit eckiger Außenkontur, auf den eine Aufsteckdichtung aufgesetzt werden kann. Dieses kann eine übliche Lippendichtung sein, aber auch eine Dichtung, wie sie Gegenstand der gleichzeitig eingereichten DE 10 2014 101 401 A1 ist.

Dadurch, dass das Innenteilprofil zur Bildung mindestens eines Profilansatzes gefalzt ist, kann bei nur halber Materialdicke somit eine bestimmte Befestigungsdicke beibehalten werden, oder diese kann trotz Materialeinspannung vergrößert werden. Damit wird genügend Materialdicke für z.B. Blechschrauben zur Verfügung gestellt, für die eine Mindestdicke erforderlich ist.

Die Hohlkammer ist vorzugsweise im Querschnitt rechteckig oder quadratisch, kann aber auch zum Beispiel trapezförmig oder als Parallelogramm, also rautenähnlich, ausgebildet sein. Weiter vorzugsweise ist der Profilansatz oder sind die Profilansätze an Kanten der Hohlkammer ausgebildet. Dabei ist vorgesehen, dass die Profilansätze mit den angrenzenden Profilseiten einen Winkel von 135° einschließen. Bei vier Profilansätzen an den vier Kanten der Hohlkammer ergibt sich somit ein symmetrisches Rahmenprofil, dessen Profilansätze unterschiedlichen Erfordernissen genügen.

Es ist bevorzugt, dass die Lochung eine Systemlochung ist. Bei zwei derartigen Profilansätzen ergeben sich mehrere Aufbauebenen, so dass mit einem geeigneten Chassis mit gleichen Teilen auf der gleichen Befestigungsebene gearbeitet werden kann. Die Montage von Komponenten ist dabei von beiden Seiten des betreffenden Profilansatzes möglich.

Aus Rahmenprofilen gemäß der vorliegenden Erfindung kann ein Rahmengestell für einen Schaltschrank aufgebaut werden, bei dem ein solches Rahmenprofil zumindest als Vertikalprofil verbaut ist, um die verbesserten Montagemöglichkeiten ausnutzen zu können. Es ist aber ebenso vorteilhaft, das Rahmenprofil gemäß der vorliegenden Erfindung auch als Horizontalprofil einzusetzen, und zwar sowohl im Decken- als auch im Bodenbereich. Gerade im Bodenbereich kann dann die Eckenlösung materialsparender ausgeführt werden, wenn das Innenteilprofil kürzer als von der Schrankabmessung benötigt ausgeführt wird, so dass es nachträglich nicht oder nur sehr wenig ausgeklinkt werden muss.

Die Erfindung wird im Folgenden anhand der beigefügten Zeichnung näher erläutert. Dabei sind die Darstellungen nicht notwendigerweise maßstabsgetreu. Es zeigt:
- Fig. 1: eine Querschnittsansicht eines Rahmenprofils gemäß der vorliegenden Erfindung;
- Fig. 2: eine Frontansicht des Rahmenprofils aus Fig. 1;
- Fig. 3: eine perspektivische Ansicht eines Innenteilprofils;
- Fig. 4: eine Eckverbindung von drei Rahmenprofilen gemäß der vorliegenden Erfindung im Deckenbereich eines Rahmengestells für einen Schaltschrank;
- Fig. 5: eine Eckverbindung im Bodenbereich eines Rahmengestells für einen Schaltschrank; und
- Fig. 6: eine Schnittdarstellung durch einen Teil eines Rahmengestells mit zwei Rahmenprofilen gemäß der vorliegenden Erfindung, anhand der die unterschiedlichen Montageebene verdeutlicht werden.

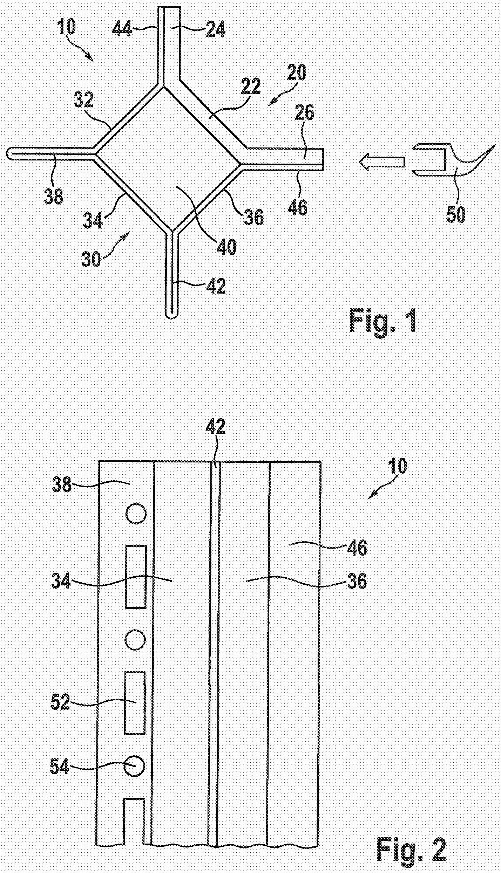

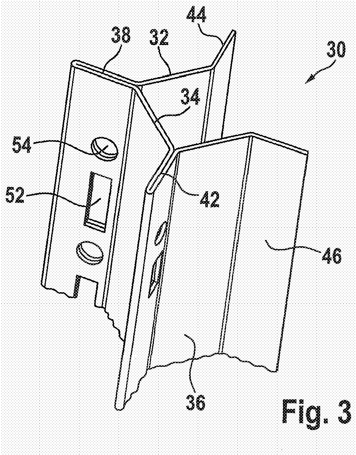

Fig. 1 zeigt eine Querschnittsdarstellung eines Rahmenprofils 10 für ein Rahmengestell eines Schaltschranks, das ein Außenteilprofil 20 aufweist, welches aus einem ersten Material hergestellt ist. Das Außenteilprofil bildet zumindest eine erste Wand 22 des Rahmenprofils 10, die eine Hohlkammer 40 teilweise begrenzt. Von der ersten Wand gehen unter einem Winkel von etwa 135° zwei Ansätze 24, 26 ab. Das Rahmenprofil 10 umfasst weiterhin ein Innenteilprofil 30, das aus einem zweiten Material hergestellt ist, welches von dem ersten Material in mindestens einer Eigenschaft unterschiedlich ist. Dies kann eine physikalische oder eine chemische Eigenschaft sein, beispielsweise kann das Außenteilprofil 20 aus einem Material hergestellt sein, das korrosionsstabiler ist als das Material des Innenteilprofils 30. Auch weist das Außenteilprofil 20 eine Wandstärke auf, die größer ist als die Wandstärke des Innenteilprofils 30. Das Innenteilprofil 30 bildet zumindest eine weitere Wand der Hohlkammer, im dargestellten Ausführungsbeispiel werden drei weitere Wände 32, 34, 36 der Hohlkammer 40 durch das Innenteilprofil 30 gebildet. Insgesamt wird so eine Hohlkammer 40 gebildet, die im Querschnitt rechteckig oder quadratisch ist. An den Kanten der Hohlkammer 40 sind Profilansätze ausgebildet, die sich von der Hohlkammer 40 weg erstrecken. Zwei verschiedene Arten von Profilansätzen sind bevorzugt, nämlich einerseits Profilansätze, die aus Ansätzen 24, 26 des Außenteilprofils 20 und damit verbundenen Ansätzen 44, 46 des Innenteilprofils 30 gebildet sind. Ein derartiger Profilansatz, beispielsweise 26, 46, ist geradlinig und hat eine eckige Außenkontur, so dass eine Aufsteckdichtung 50 einfach aufzuschieben ist. Weitere Profilansätze 38, 42 sind dadurch gebildet, dass das Material des Innenteilprofils 30 gefalzt wird, so dass die Profilansätze 38, 42 sozusagen doppellagig aus dem Material des Innenteilprofils 30 ausgeführt sind. Diese gefalzten Profilansätze 38, 42 weisen Lochungen auf, die besser in den Fig. 2 und 3 zu erkennen sind.

Der Hohlraum 40 kann zur Kabelführung genutzt werden. Auch Befüllungen mit Hartschaum oder Weichschaum, beispielsweise auf Polyester- oder Polyurethanbasis, ist möglich, um das Rahmenprofil 10 zu versteifen oder ihm Dämpfungseigenschaften zu verleihen.
Fig. 2 zeigt eine Draufsicht auf das Profil der Fig. 1. Am Profilansatz 38 ist die Lochung zu erkennen, die aus abwechselnd rechteckigen und kreisrunden Lochungen 52, 54 besteht. Eine ähnliche Lochung, die auch als Systemlochung bezeichnet wird, ist im Profilansatz 42 vorgesehen, dort aber in der Darstellung nicht erkennbar. Die Profilansätze 38, 42 gehen über die Wand 34 ineinander über, wobei sie sich unter einem Winkel von etwa 135° von dieser erstrecken (siehe Fig. 1). Der Profilansatz 42 geht über eine Wand 36 in den Ansatz 46 über, wobei auch hier die Übergangswinkel in der Größenordnung von 135° liegen.

Die winklige Ausgestaltung des Innenteilprofils 30 ist deutlich in der Fig. 3 zu erkennen, die das Innenteilprofil 30 in einer perspektivischen Draufsicht zeigt. Die gefalzten Profilansätze 38, 42 zeigen die Systemlochung aus Rechtecken 52 und kreisrunden Öffnungen 54. Verschiedene Systemlochungen sind möglich, beispielsweise eine 19"-Lochungen oder eine metrische Lochung. Durch das Falzen sind die Profilansätze 38, 42 mit doppelter Wandstärke wie die Wände 32, 34, 36 bzw. die Ansätze 44, 46 ausgebildet, so dass die notwendige Stabilität zum Anbringen von Komponenten gegeben ist. Das Innenteilprofil 30 kann als Blech-Biegestanzteil hergestellt werden und wird dann mittels eines Außenteilprofils (Fig. 2) zu einem Rahmenprofil 10 gemäß der vorliegenden Erfindung ergänzt.

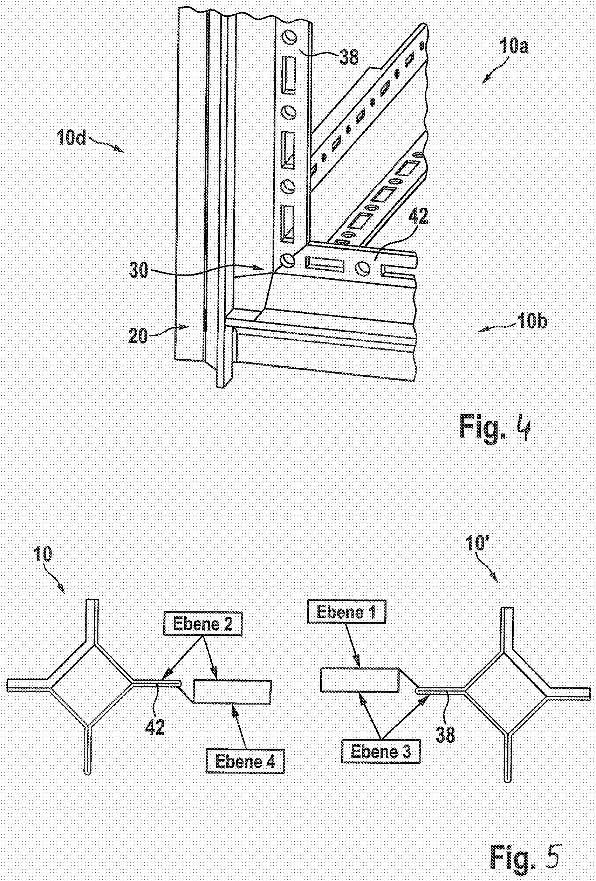

Eine Eckverbindung im Bodenbereich eines Rahmengestells mit Rahmenprofilen 10a, 10b und 10d gemäß der vorliegenden Erfindung ist in Fig. 4 gezeigt. Das Innenteilprofil 30 des vertikalen Rahmenprofils 10d ist dabei kürzer ausgeführt, als es von der Schrankabmessung benötigt wird. Dies bedeutet eine Materialersparnis, außerdem muss nachträglich nicht oder nur sehr wenig ausgeklinkt werden. Die horizontalen Rahmenprofile 10a, 10b sind an ihren Profilansätzen 38, 42 auf Gehrung geschnitten, wobei dann gegebenenfalls noch notwendige Anpassungen des Innenteilprofils 30 an die Geometrie der Ecke erfolgt. Das Außenteilprofil 20 muss nicht weiter bearbeitet werden.

Fig. 5 zeigt eine Querschnittsansicht eines Teils eines Rahmengestells, das aus Rahmenprofilen 10, 10' gemäß der vorliegenden Erfindung aufgebaut ist. Durch die gelochten, gefalzten Profilansätze 38, 42 ist eine Montage von Aufbaukomponenten, z.B. von Chassis, von beiden Seiten der Profilansätze 38, 42 ermöglicht. Mit geeigneten Chassis können so mit gleichen Teilen auf der gleichen Befestigungsebene verschiedene Aufbauebenen realisiert werden, wie es durch Ebene 1, Ebene 2, Ebene 3 und Ebene 4 angezeigt ist.

Das Rahmenprofil gemäß der vorliegenden Erfindung bietet somit eine Materialersparnis, ohne die Funktionalität einzuschränken.

Die in der vorstehenden Beschreibung, in den Zeichnungen sowie in den Ansprüchen offenbarten Merkmale der Erfindung können sowohl einzeln als auch in beliebiger Kombination für die Verwirklichung der Erfindung wesentlich sein, wie in den beigefügten Ansprüchen definiert.

## Patentansprüche

1. Rahmenprofil für ein Rahmengestell eines Schaltschrankes, bestehend aus
- einem Außenteilprofil (20), das aus einem ersten Material hergestellt ist, wobei das Außenteilprofil (20) zumindest eine erste Wand (22) des Rahmenprofils (10), die eine Hohlkammer (40) teilweise begrenzt, bildet; und
- einem Innenteilprofil (30), das aus einem zweiten Material hergestellt ist, welches von dem ersten Material in mindestens einer Eigenschaft unterschiedlich ist, wobei das Innenteilprofil (30) zumindest eine weitere Wand (32, 34, 36) der Hohlkammer (40) bildet,
**dadurch gekennzeichnet, dass** die Hohlkammer (40) über die Länge des Rahmenprofils (10) durchgängig ausgeführt und das Innenteilprofil (30) zur Bildung mindestens eines Profilansatzes (38, 42) gefalzt ist, der mit einer Lochung (52, 54) versehen ist.

2. Rahmenprofil nach Anspruch 1, **dadurch gekennzeichnet, dass** die Stärke des Außenteilprofils (20) von der Stärke des Innenteilprofils (30) unterschiedlich ist.

3. Rahmenprofil nach Anspruch 1, **dadurch gekennzeichnet, dass** die Hohlkammer (40) mit einem Hartschaum versteift ist.

4. Rahmenprofil nach Anspruch 1, **dadurch gekennzeichnet, dass** die Hohlkammer (40) mit einem Weichschaum befüllt ist.

5. Rahmenprofil nach Anspruch 4, **dadurch gekennzeichnet, dass** die Hohlkammer (40) mit einem offenporigen Weichschaum befüllt ist.

6. Rahmenprofil nach einem der Ansprüche 1 bis 4, **dadurch gekennzeichnet, dass** der Hartschaum oder Weichschaum ein Schaum auf Polyester- oder Polyurethanbasis ist.

7. Rahmenprofil nach Anspruch 1, **dadurch gekennzeichnet, dass** die Hohlkammer (40) mit einem anorganischen Material, wie Metallschaum oder Beton, befüllt ist.

8. Rahmenprofil nach Anspruch 1, **dadurch gekennzeichnet, dass** das Außenteilprofil (20) und das Innenteilprofil (30) zu zumindest einem Profilansatz (24, 44; 26, 46) zusammengeführt sind, der sich von der Hohlkammer (40) weg erstreckt.

9. Rahmenprofil nach Anspruch 1, **dadurch gekennzeichnet, dass** die Hohlkammer (40) im Querschnitt rechteckig, quadratisch, trapezförmig oder rautenähnlich ist.

10. Rahmenprofil nach Anspruch 8, **dadurch gekennzeichnet**, das der Profilansatz oder die Profilansätze (24, 44; 26, 46; 38; 42) an Kanten der Hohlkammer (40) ausgebildet sind.

11. Rahmenprofil nach Anspruch 1, **dadurch gekennzeichnet, dass** die Profilansätze (24, 44; 26, 46; 38; 42) mit den angrenzenden Profilseiten (22, 32, 34, 36) einen Winkel von 135° einschließen.

12. Rahmenprofil nach Anspruch 1, **dadurch gekennzeichnet, dass** die Lochung (52, 54) eine Systemlochung ist.

13. Rahmengestell für einen Schaltschrank, bei dem ein Rahmenprofil nach einem der Ansprüche 1 bis 12 zumindest als Vertikalprofil verbaut ist.

## Claims

1. A frame profile for a frame rack of a switch cabinet, consisting of
- an outer profile part (20) manufactured from a first material, wherein the outer profile part (20) forms at least a first wall (22) of the frame profile (10) which partially limits a hollow chamber (40); and
- of an inner profile part (30) manufactured from a second material which differs from the first material by at least one quality, wherein the inner profile part (30) forms at least one other wall (32, 34, 36) of the hollow chamber (40),
**characterized in that** the hollow chamber (40) is constructed to be open over the length of the frame profile (10) and that the inner profile part (30) is folded in order to form at least one profile attachment (38, 42) which is provided with perforations (52, 54).

2. The frame profile according to Claim 1, **characterized in that** the thickness of the outer profile part (20) differs from the thickness of the inner profile part (30).

3. The frame profile according to Claim 1, **characterized in that** the hollow chamber (40) is reinforced with a hard foam.

4. The frame profile according to Claim 1, **characterized in that** the hollow chamber (40) is reinforced with a soft foam.

5. The frame profile according to Claim 4, **characterized in that** the hollow chamber (40) is filled with a soft foam with open pores.

6. The frame profile according to one of Claims 1 to 4, **characterized in that** the hard foam or soft foam is a foam based on polyester or polyurethane.

7. The frame profile according to Claim 1, **characterized in that** the hollow chamber (40) is filled with an inorganic material such as metallic foam or concrete.

8. The frame profile according to Claim 1, **characterized in that** the outer profile part (20) and the inner profile part (30) are brought together to at least one profile attachment (24, 44; 26, 46) which extends away from the hollow chamber (40).

9. The frame profile according to Claim 1, **characterized in that** the hollow chamber (40) is rectangular, quadratic, trapezoidal or like a rhombus in cross section.

10. The frame profile according to Claim 8, **characterized in that** the profile attachment or the profile attachments (24, 44; 26, 46; 38; 42) is/are constructed on edges of the hollow chamber (40).

11. The frame profile according to Claim 1, **characterized in that** the profile attachments (24, 44; 26, 46; 38; 42) enclose an angle of 135° with the adjacent profile sides (22, 32, 34, 36).

12. The frame profile according to Claim 1, **characterized in that** the perforations (52, 54) are system perforations.

13. A frame rack for a service cabinet in which a frame profile according to one of Claims 1 to 12 is constructed at least as a vertical profile.

## Revendications

1. Profilé de châssis pour un châssis d'une armoire de commande, constitué de:
- un profilé partiel externe (20) qui est constitué d'un premier matériau, le profilé partiel externe (20) formant au moins une première paroi (22) du profilé partiel externe (10), qui limite partiellement une chambre creuse (40); et
- un profilé partiel interne (30), qui est constitué d'un deuxième matériau, qui est différent du premier matériau en ce qui concerne au moins une propriété, le profilé partiel interne (30) formant au moins une autre paroi (32, 34, 36) de la chambre creuse (40),
**caractérisé en ce que** la chambre creuse (40) est réalisée de manière continue sur la longueur du profilé de châssis (10) et le profilé partiel interne (30) est plié pour la formation d'au moins une extension de profilé (38, 42) qui est munie d'une perforation (52, 54).

2. Profilé de châssis selon la revendication 1, **caractérisé en ce que** l'épaisseur du profilé partiel externe (20) est différente de l'épaisseur du profilé partiel interne (30).

3. Profilé de châssis selon la revendication 1, **caractérisé en ce que** la chambre creuse (40) est rigidifiée avec une mousse dure.

4. Profilé de châssis selon la revendication 1, **caractérisé en ce que** la chambre creuse (40) est remplie d'une mousse souple.

5. Profilé de châssis selon la revendication 4, **caractérisé en ce que** la chambre creuse (40) est remplie d'une mousse souple à cellules ouvertes.

6. Profilé de châssis selon l'une des revendications 1 à 4, **caractérisé en ce que** la mousse dure ou la mousse souple est une mousse à base de polyester ou de polyuréthane.

7. Profilé de châssis selon la revendication 1, **caractérisé en ce que** la chambre creuse (40) est remplie d'un matériau inorganique, comme une mousse métallique ou du béton.

8. Profilé de châssis selon la revendication 1, **caractérisé en ce que** le profilé partiel externe (20) et le profilé partiel interne (30) sont regroupés en au moins une extension de profilé (24, 44 ; 26, 46) qui s'éloigne de la chambre creuse (40).

9. Profilé de châssis selon la revendication 1, **caractérisé en ce que** la chambre creuse (40) présente une section transversale de forme rectangulaire, carrée, trapézoïdale ou semblable à un losange.

10. Profilé de châssis selon la revendication 8, **caractérisé en ce que** l'extension de profilé ou les extensions de profilés (24, 44 ; 26, 46 ; 38 ; 42) sont réalisées sur des arêtes de la chambre creuse (40).

11. Profilé de châssis selon la revendication 1, **caractérisé en ce que** les extensions de profilés (24, 44 ; 26, 46 ; 38 ; 42) forment, avec les côtés des profilés adjacents (22, 32, 34, 36), un angle de 135°.

12. Profilé de châssis selon la revendication 1, **caractérisé en ce que** la perforation (52, 54) est une perforation systématique.

13. Châssis pour une armoire de commande, dans lequel un profilé de châssis est construit au moins comme un profilé vertical selon l'une des revendications 1 à 12.
